# EUROPEAN PATENT APPLICATION

(11) **EP 4 564 410 A1**
(43) Date of publication of application: **04.06.2025**
(21) Application number: 23847023.1
(22) Date of filing: 27.07.2023
(51) Int. Cl.: H01L 21/67, B01D 53/00, B01D 46/00

(54) **HIGH-PRESSURE SUBSTRATE PROCESSING APPARATUS**

(30) Priority: 29.07.2022 KR 20220094908
(71) Applicant: HPSP Co., Ltd., Hwaseong-si, Gyeonggi-do 18449 (KR)
(72) Inventor: LIM, Kunyoung, Suwon-si, Gyeonggi-do 16642 (KR); YOON, Hyeseong, Suwon-si, Gyeonggi-do 16642 (KR)
(74) Representative: von Bülow & Tamada
(86) International application number: PCT/KR2023/010944
(87) International publication number: WO 2024/025366

(57) **Abstract**

The present invention provides a high-pressure substrate processing apparatus comprising: an inner chamber for accommodating a substrate to be processed; an outer chamber that includes a hollow housing and a partition plate arranged to partition the housing into a high-temperature region accommodating the inner chamber and a low-temperature region having a lower temperature than the high-temperature region; an air supply module configured to supply a reaction gas for processing the substrate to the inner chamber at a first pressure higher than atmospheric pressure and supply a protective gas to a space between the outer chamber and the inner chamber at a second pressure set in relation to the first pressure; an air discharge module which is provided with an air discharge pipe communicating with the inner chamber and passing through the low-temperature region and which is configured to discharge a mixed gas containing the reaction gas and by-products formed by processing the substrate; and a collection module which is disposed in the low-temperature region while communicating with the air discharge pipe and which is configured to collect the by-products in the mixed gas.

## Description

### [Technical Field]

The present invention relates to a processing apparatus for processing a substrate in a high-pressure environment.

### [Background Art]

In general, various processing may be performed on a semiconductor substrate during a manufacturing process of a semiconductor device. Examples of the processing may include oxidation, nitriding, silicide, ion implantation, deposition, and other similar processes. The examples may also include a hydrogen or deuterium heat treatment process to improve interface properties of the semiconductor device.

A gas used for the processing may be supplied into a chamber and act on the semiconductor substrate. During such action, byproducts such as particles may be released from the semiconductor substrate.

In an exhaust stage of the processing process, the byproducts may be discharged while being mixed with the gas used in the process. The byproducts may be gaseous in a high-pressure environment, and solidified either during a process of leaving a processing equipment or after leaving the processing equipment.

The solidified byproducts may accumulate on an inside wall of a gas exhaust line, a gas discharge valve, another scrubber, or a vacuum pump. Accordingly, a flow path may be clogged in the lines and various devices, thus causing a problem. A section where the problem occurs may be quite long along the flow path of the gas and the byproducts.

In response, a device, such as a cold trap, has been used to capture the byproducts. The cold trap may cool the discharged gas to capture the byproducts, and its cooling performance may determine byproduct capture efficiency. The cold trap has traditionally been installed directly in front of the scrubber, thus addressing the problem of clogging in the flow path between the scrubber and the vacuum pump.

### [Disclosure]

### [Technical Problem]

An object of the present invention is to provide a high-pressure substrate processing apparatus that is capable of removing byproducts within a chamber, thus preventing an adverse effect of the byproducts from extending beyond the chamber.

Another object of the present invention is to provide a high-pressure substrate processing apparatus that eliminates the need for a high level of high-pressure design for a byproduct capture module used in high-pressure processing for a substrate.

### [Technical Solution]

According to an embodiment of the present invention, provided is a high-pressure substrate processing apparatus including: an inner chamber accommodating a substrate to be processed; an outer chamber including a hollow housing and a partition plate partitioning the housing into a high-temperature region accommodating the inner chamber and a low-temperature region having a lower temperature than the high-temperature region; a gas supply module configured to supply a reaction gas for processing the substrate to the inner chamber at a first pressure higher than atmospheric pressure, and to supply a protective gas to a space between the outer chamber and the inner chamber at a second pressure set in relation to the first pressure; a gas exhaust module including a gas exhaust line communicating with the inner chamber and passing through the low-temperature region and configured to exhaust a mixed gas including the reaction gas and byproducts occurring due to the processing; and a capture module disposed in the low-temperature region while communicating with the gas exhaust line and configured to capture the byproducts in the mixed gas.

The gas exhaust module may further include a gas discharger installed at the gas exhaust line to be disposed outside the outer chamber and configured to regulate the mixed gas to be discharged to the outside through the capture module, and the capture module may be disposed in front of the gas discharger.

The apparatus may further include a cooling water supply module including a cooling water supply line, wherein the capture module is configured to cool the mixed gas by using cooling water flowing along the cooling water supply line, thus causing the byproducts to become powder.

The capture module may include a pair of gas exhaust line connections detachably connected to the gas exhaust line, and a pair of cooling water supply line connections detachably connected to the cooling water supply line.

The pair of gas exhaust line connections may be arranged along an extension direction of the gas exhaust line, and the pair of cooling water supply line connections may be arranged along an intersecting direction intersecting the extension direction.

The cooling water supply module may be configured to supply the cooling water to one of the housing and the partition plate to cool the low-temperature region.

The apparatus may further include: a detection module including a temperature sensor configured to measure a temperature in the gas exhaust line; and a control module connected to the temperature sensor and the cooling water supply module, wherein the control module is configured to regulate a temperature of the cooling water based on the temperature in the gas exhaust line that is acquired from the temperature sensor.

The cooling water supply module may further include a chiller configured to cool the cooling water, and the control module may operate the chiller to lower the temperature of the cooling water.

The apparatus may further include: a detection module including a pressure sensor configured to measure a pressure in the gas exhaust line at a rear end of the capture module; and a control module connected to the pressure sensor, wherein the control module is configured to output a replacement time of the capture module based on the pressure in the gas exhaust line that is acquired from the pressure sensor.

According to another embodiment of the present invention, provided is a high-pressure substrate processing apparatus including: an inner chamber accommodating a substrate to be processed; an outer chamber including a hollow housing accommodating the inner chamber; a gas supply module configured to supply a reaction gas for processing the substrate to the inner chamber at a first pressure higher than atmospheric pressure, and to supply a protective gas to a space between the outer chamber and the inner chamber at a second pressure set in relation to the first pressure; a gas exhaust module including a gas exhaust line communicating with the inner chamber and configured to exhaust a mixed gas including the reaction gas and byproducts occurring due to the processing to the outside of the outer chamber; and a capture module disposed in the outer chamber while communicating with the gas exhaust line, exposed externally to the second pressure by the protective gas, exposed internally to the first pressure by the reaction gas, and configured to capture the byproducts in the mixed gas.

A difference between the first pressure and the second pressure may be 2 atmospheres (ATM) or less.

The gas exhaust module may further include a gas discharger installed at the gas exhaust line and configured to regulate the exhaust of the mixed gas, and the capture module may be disposed in front of the gas discharger.

The apparatus may further include a heating module configured to heat the reaction gas for processing the substrate, wherein the outer chamber further includes a partition plate partitioning the housing into a high-temperature region accommodating the inner chamber and the heating module and a low-temperature region having a lower temperature than the high-temperature region, and the low-temperature region is filled with cold air.

The apparatus may further include a cooling water supply module, wherein the capture module is configured to cool the mixed gas by using cooling water supplied by the cooling water supply module, thus causing the byproducts to become powder, and the low-temperature region generates the cold air through the cooling water supplied to one of the housing and the partition plate by the cooling water supply module.

### [Advantageous Effects]

In the high-pressure substrate processing apparatus according to the present invention configured as above, the problem caused by the byproducts may be prevented from extending beyond the outer chamber because the capture module is operated by being installed at the gas exhaust line within the outer chamber when the gas in the inner chamber is exhausted while the gas at the first pressure or the second pressure is supplied to each of the inner chamber accommodating the substrate and the outer chamber surrounding the inner chamber.

The high-pressure design may not be required for the capture module despite the high pressure substrate processing because the capture module is exposed internally to the first pressure by communicating with the inner chamber and exposed externally to the second pressure set in the certain relationship with the first pressure.

The byproducts may be captured more efficiently because the capture module cools the exhaust gas from the inner chamber more powerfully as the capture module is disposed in the low-temperature region, which is distinct from the high-temperature region within the outer chamber.

### [Description of Drawings]

FIG. 1 is a conceptual diagram of a high-pressure substrate processing apparatus 100 according to an embodiment of the present invention.
FIG. 2 is a partial cross-sectional view showing a specific relationship among the chambers 110 and 120 and capture module 150 of FIG. 1.
FIG. 3 is a conceptual diagram showing a connection relationship among the capture module 150 of FIG. 1, a cooling water supply module 170, and a detection module 180.
FIG. 4 is a block diagram showing a control configuration for the high-pressure substrate processing apparatus 100 of FIG. 1.
FIG. 5 is a perspective view showing a structure of the capture module 150 of FIG. 1.

### [Detailed Description]

Hereinafter, a high-pressure substrate processing apparatus according to embodiments of the present invention is described in detail with reference to the accompanying drawings. Throughout the present invention, components that are the same as or similar to each other are denoted by reference numerals that are the same as or similar to each other even in a different embodiment, and a description thereof is replaced by the first description.

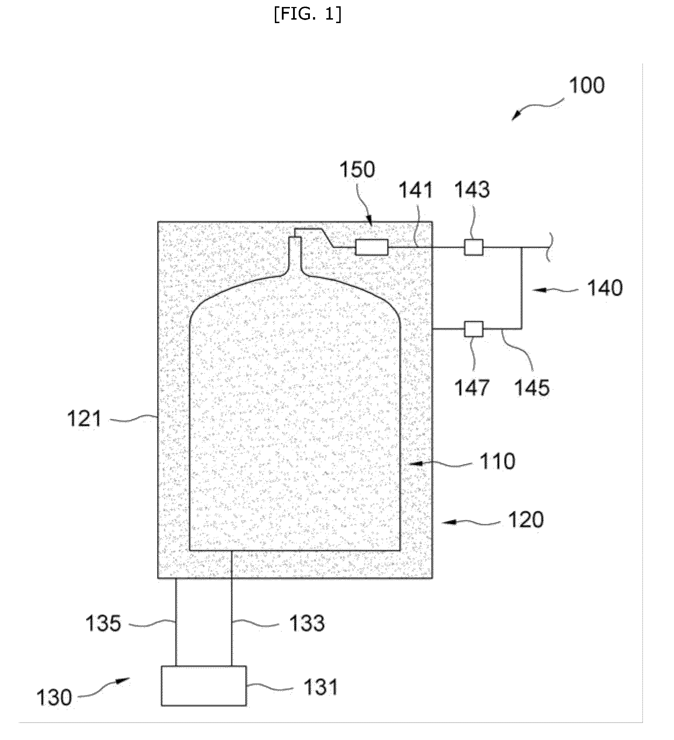

FIG. 1 is a conceptual diagram of a high-pressure substrate processing apparatus 100 according to an embodiment of the present invention.

Referring to this drawing, the high-pressure substrate processing apparatus 100 may include an inner chamber 110, an outer chamber 120, a gas supply module 130, a gas exhaust module 140, and a capture module 150.

The inner chamber 110 may form a reaction space that accommodates an object to be processed. The inner chamber 110 may be made of a non-metallic material, such as quartz, to reduce contamination in a high temperature and high pressure working environment. Although simplified in the drawings, the inner chamber 110 may have a door at the bottom to open the reaction space. The reaction space may be opened as the door descends, and the object may be put into the inner chamber 110 while being mounted on a holder (not shown). The object may be, for example, a semiconductor substrate. In this case, the holder may be a wafer boat capable of stacking the semiconductor substrates on a plurality of layer.

The outer chamber 120 may completely surround the inner chamber 110. Unlike the inner chamber 110, the outer chamber 120 may be made of a metal because the outer chamber 120 is free from the contamination problem. The outer chamber 120 may include a hollow housing 121 having an inner space that accommodates the inner chamber 110. The housing 121 may also have a door at the bottom, which may be opened in conjunction with the door of the inner chamber 110 when the inner chamber door is opened.

The gas supply module 130 is a component for supplying a gas to the inner chamber 110 and the outer chamber 120. The gas supply module 130 may have a gas supplier 131 that serves as a gas source. The gas supplier 131 may selectively provide, for example, hydrogen/deuterium, fluorine, ammonia, chlorine, nitrogen, or the like as a reaction gas for the inner chamber 110. The gas supplier 131 may provide, for example, nitrogen, which is an inert gas, as a protective gas for the outer chamber 120. The reaction gas and the protective gas may be supplied to the inner chamber 110 and the outer chamber 120 through a reaction gas line 133 and a protective gas line 135, respectively. The protective gas supplied to the outer chamber 120 may specifically fill a space between the outer chamber 120 and the inner chamber 110.

The reaction gas and the protective gas may be supplied to form a high pressure, for example, several atmospheres (ATM) to several tens ATM, which is a pressure higher than the atmospheric pressure. When the pressure of the reaction gas is a first pressure and the pressure of the protective gas is a second pressure, these pressures may be maintained at a set relationship (range). For example, the second pressure may be set to be slightly larger than the first pressure. A pressure difference between the first pressure and the second pressure may be, for example, 2 ATM or less. The pressure difference may prevent the reaction gas from leaking out of the inner chamber 110.

The gas exhaust module 140 is a component for exhausting the reaction gas and the protective gas. First, a gas exhaust line 141 may be connected to the inner chamber 110 in order to exhaust the reaction gas from the inner chamber 110. The gas exhaust line 141 may be connected to an upper part of the inner chamber 110 and extend out of the outer chamber 120. A gas discharger 143 may be installed at the gas exhaust line 141. The gas discharger 143 may be a gas discharge valve that regulates the exhaust of the reaction gas. The first pressure may be maintained or regulated to be lower depending on an operation of the gas discharger 143. The reaction gas may be mixed with byproducts resulting from processing of the substrate. The reaction gas and the byproducts may be mixed with each other, and thus be collectively referred to as a mixed gas.

Similarly, a gas exhaust line 145 communicating with the outer chamber 120 and a gas discharger 147 installed therein may be provided to discharge the protective gas from the outer chamber 120. These gas exhaust lines 141 and 145 may be connected to each other, and the reaction gas may thus be diluted with the protective gas to have a lower concentration.

The capture module 150 is a component for capturing the byproducts in the mixed gas flowing along the gas exhaust line 141. The capture module 150 may be disposed in the outer chamber 120 while communicating with the gas exhaust line 141. The capture module 150 may also be disposed in front of the gas discharger 143 along a gas discharge direction from the gas exhaust line 141.

According to this configuration, the capture module 150 may be disposed within the outer chamber 120, and the byproducts may thus be captured within the outer chamber 120. As a result, the byproducts may be prevented from having an adverse effect on a related device such as a part of the gas exhaust line 141 that follows the capture module 150, the gas discharger 143, or a scrubber, beyond the outer chamber 120.

The gas discharger 143 may discharge the reaction gas from the inner chamber 110 to regulate, mainly lower, the first pressure. Regulating the first pressure may involve regulating the second pressure, which has the set relationship with the first pressure. The byproducts may not be mixed with the protective gas, and the gas discharger 147 for regulating the second pressure may thus be operated without being adversely affected by the byproducts. Accordingly, the gas discharger 143 for regulating the first pressure may need to be operated normally without being adversely affected by the byproducts. For this purpose, the capture module 150 may be disposed in front of the gas discharger 143. The normal operation of the gas discharger 143 influenced by the capture module 150 may be important not only for regulating the first pressure but also for regulating the second pressure related to the first pressure.

The capture module 150 may be exposed internally to the first pressure because the capture module 150 communicates with the inner chamber 110 through the gas exhaust line 141. The capture module 150 may be exposed externally to the second pressure due to the protective gas. The second pressure may maintain its set relationship with the first pressure, and their pressure difference may not be great. Even if the first pressure reaches tens of atmospheres, the capture module 150 may be exposed to the pressure difference rather than the first pressure. Accordingly, the capture module 150 may not need to have a high-level high-pressure design corresponding to tens of atmospheres.

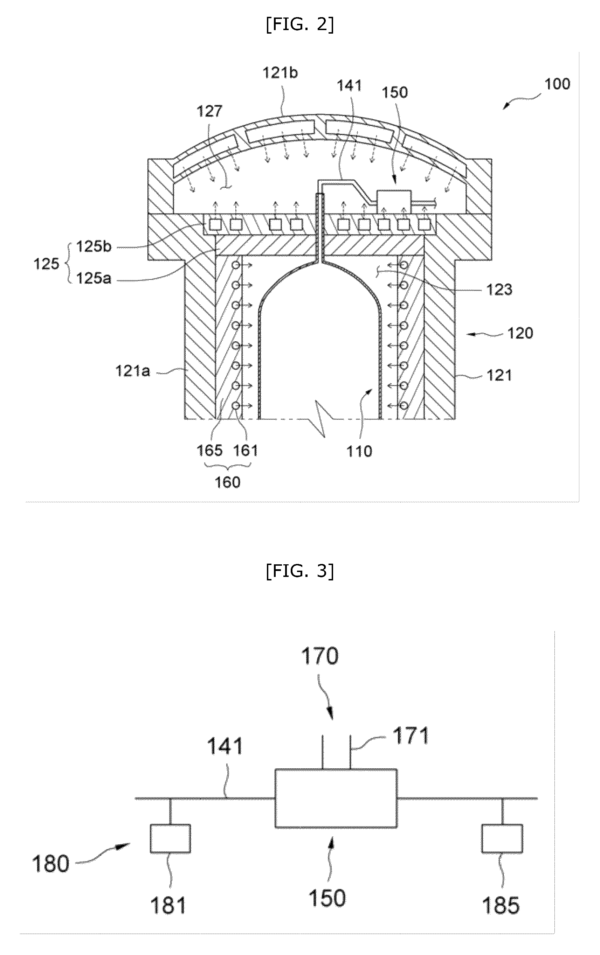

FIG. 2 is a partial cross-sectional view showing a specific relationship among the chambers 110 and 120 and capture module 150 of FIG. 1.

Referring to this drawing, the housing 121 of the outer chamber 120 may include a body part 121a and a cover part 121b. The body part 121a may have a substantially cylindrical shape, and the cover part 121b may have a shape corresponding to an open top of the body part 121a. The cover part 121b may have a substantially dome shape.

The space defined by the housing 121, i.e., inner space, may be partitioned into two regions by a partition plate 125. The partition plate 125 may be disposed below the cover part 121b while being supported by the body part 121a. The partition plate 125 may define a high-temperature region 123 together with the body part 121a, and define a low-temperature region 127 together with the cover part 121b. The high-temperature region 123 and the low-temperature region 127 may communicate with each other through a communication hole (not shown) or the like formed in the partition plate 125, and thus have the same pressure (second pressure).

In the high-temperature region 123a, a heating module 160 may also be disposed in addition to the inner chamber 110. The heating module 160 may include a heater 161 and a heat insulation block 165. The heater 161 may surround the inner chamber 110. The protective gas in the high-temperature region 123 and the reaction gas in the inner chamber 110 may be heated by heat generated by the heater 161. A temperature of the reaction gas may reach hundreds to thousands of degrees Celsius due to the operation of the heater 161. The heat insulation block 165 may embed the heater 161, and prevent heat generated by the heater 161 from being transferred to the body part 121a.

A heat insulation layer 125a may be disposed on a lower part of the partition plate 125 to correspond to the heater 161. The heat insulation layer 125a may be disposed on top of the heating module 160 to face the heater 161. The heat insulation layer 125a may block heat generated by the heater 161 from being transferred to the low-temperature region 127.

A cooling layer 125b may be disposed on an upper part of the partition plate 125. The cooling layer 125b may have a space that accommodates a cooling medium, for example, cooling water. The cover part 121b may also have a space that accommodates the cooling water to correspond to the cooling layer 125b. The cover part 121b may accommodate a larger amount of cooling water than the partition plate 125.

The cooling water accommodated in the cover part 121b and/or the cooling layer 125b may fill the low-temperature region 127 with cold air. Accordingly, a temperature in the low-temperature region 127 may be maintained to be significantly lower than that in the high-temperature region 123, for example, a tenth or less of the temperature in the high-temperature region 123.

The capture module 150 may be installed at the gas exhaust line 141 passing through the low-temperature region 127 while being disposed in the low-temperature region 127. The capture module 150, as well as the gas remaining in the gas exhaust line 141 and the capture module 150 among the reaction gas may be affected by the cold air.

According to this configuration, the mixed gas may flow from the high-temperature region 123 to the low-temperature region 127 to pass through the capture module 150. Accordingly, the mixed gas may pass through the capture module 150 at a temperature significantly lower than a high temperature at which the substrate is processed. The low-temperature region 127 may function to improve the cooling performance of the capture module 150 by providing preliminary or preemptive cooling of the mixed gas. As a result, a cooling load in the capture module 150 may be reduced or the cooling efficiency of the capture module 150 may be increased. The capture efficiency of the capture module 150 may also be improved.

A connection relationship between the capture module 150 and its peripheral components is described with reference to FIG. 3. FIG. 3 is a conceptual diagram showing the connection relationship among the capture module 150 of FIG. 1, a cooling water supply module 170, and a detection module 180.

Referring to this drawing, the capture module 150 may communicate with the gas exhaust line 141 as described above. The capture module 150 may also communicate with a cooling water supply line 171 of the cooling water supply module 170.

The cooling water supply module 170 may also supply the cooling water to another component other than the capture module 150 through the cooling water supply line 171 and another supply line (not shown). The cooling water may also be supplied to the cover part 121b of the outer chamber 120 or the cooling layer 125b (see FIG. 2) described above by the cooling water supply module 170.

The cooling water flowing in the cooling water supply line 171 may cool the mixed gas flowing in the capture module 150. The byproducts may be present as the gas in the high-pressure environment, and solidified into powder as the byproducts are cooled. The powder may accumulate within the capture module 150 and be prevented from escaping the outer chamber 120.

The detection module 180 that acquires information related to the capture module 150 may be introduced in order to efficiently operate the capture module 150 and determine a replacement time. The detection module 180 may employ a temperature sensor 181 and a pressure sensor 185.

The temperature sensor 181 may measure a temperature in the gas exhaust line 141. The temperature sensor 181 may be disposed upstream of the capture module 150 to thus measure a temperature of the mixed gas flowing into the gas exhaust line 141.

The pressure sensor 185 may measure a pressure in the gas exhaust line 141. The pressure sensor 185 may be disposed downstream of the capture module 150 to thus measure the pressure (its change) due to the presence of the gas exhaust line 141 where the powder accumulates.

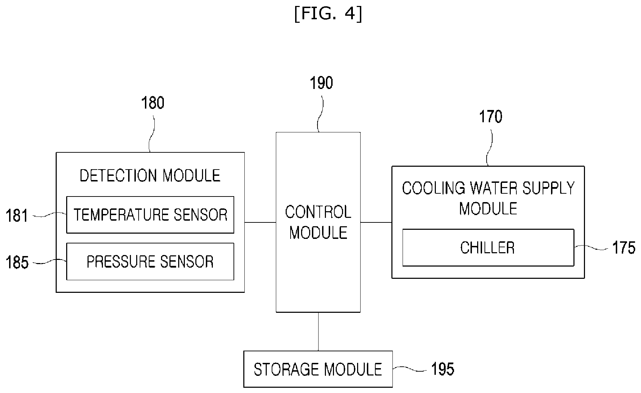

A control based on the information acquired from the detection module 180 described above is described with reference to FIG. 4. FIG. 4 is a block diagram showing a control configuration for the high-pressure substrate processing apparatus 100 of FIG. 1.

Referring to this drawing, the cooling water supply module 170 may further include a chiller 175. The chiller 175 may lower a temperature of the cooling water supplied through the cooling water supply line 171 or the like.

The processing apparatus 100 may further include a control module 190 and a storage module 195 in addition to the cooling water supply module 170. The control module 190 may be connected to the detection module 180 and the cooling water supply module 170. The control module 190 is a component for controlling the cooling water supply module 170 or outputting the replacement time of the capture module 150 based on a detection result of the detection module 180. The storage module 195 is a component for storing data, programs, or the like that the control module 190 may refer to for the control.

The control module 190 may receive a temperature at a tip of the gas exhaust line 141 from the temperature sensor 181 connected thereto. The temperature at the tip of the gas exhaust line 141 may be hundreds to thousands of degrees Celsius corresponding to a temperature in the inner chamber 110. The control module 190 may regulate the temperature of the cooling water based on the temperature in the gas exhaust line 141 and the temperature in the low-temperature region 127. The temperature of the cooling water may be further lowered if the temperature in the gas exhaust line 141 is high. The control module 190 may operate the chiller 175 to further lower the temperature of the cooling water. An operation level of the chiller 175 may be determined by the control module 190 with reference to the storage module 195.

The control module 190 may also receive a pressure at a rear end of the gas exhaust line 141 from the pressure sensor 185. The pressure in the gas exhaust line 141 may vary depending on a condition of the capture module 150. The pressure in the gas exhaust line 141 may be changed if in a case where the capture module 150 is used fora long time compared to a case where the capture module 150 is used for a short time. The reason is that the flow path in the capture module 150 becomes narrower as the powder accumulates in the capture module 150. The control module 190 may calculate the replacementtime of the capture module 150 based on such a pressure change. If the capture module 150 needs to be replaced, the control module 190 may cause this need to be alarmed through a buzzer, a display or the like, or transmitted to a management computer. A specific degree (time point) of the replacement time may be determined by the control module 190 with reference to the storage module 195.

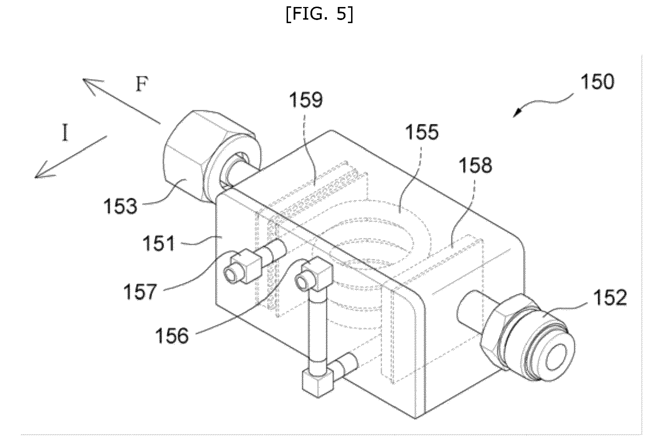

A specific structure of the capture module 150 described above is described with reference to FIG. 5. FIG. 5 is a perspective view showing the structure of the capture module 150 of FIG. 1.

Referring to this drawing, the capture module 150 may include a body 151, a pair of gas exhaust line connections 152 and 153, a cooling water coil 155, a pair of cooling water supply line connections 156 and 157, and filters 158 and 159.

The body 151 may be a hollow body having an inner space. The body 151 may have, for example, a hexahedral shape. The body 151 may be made of a metal material.

The pair of gas exhaust line connections 152 and 153 may respectively be coupled to both sides of the body 151. In detail, the connections 152 and 153 may be arranged in a row along a flow direction F of the mixed gas (extension direction of the gas exhaust line 141). The inlet gas exhaust line connection 152, which is one of the pair, may be coupled to a right side of the body 151, and the outlet gas exhaust line connection 153, which is the other of the pair, may be coupled to a left side of the body 151. The connections 152 and 153 are detachably coupled to the gas exhaust line 141. The connections 152 and 153 may also allow the mixed gas to communicate with the inner space of the body 151.

The cooling water coil 155 is a componentthat is disposed in the inner space of the body 151 to cool the mixed gas. The cooling water coil 155 may be wound into a coil shape, thus maximizing a time during which the cooling water remains in the body 151.

The pair of cooling water supply line connections 156 and 157 are components installed at both ends of the cooling water coil 155. The connections 156 and 157 may allow the cooling water coil 155 to be detachably connected to the cooling water supply line 171 (see FIG. 2). One of the connections 156 and 157 may receive the cooling water from the cooling water supply line 171, and the other may return the cooling water that passed through the cooling water coil 155 to the cooling water supply line 171. The connections 156 and 157 may be arranged along an intersecting direction I intersecting the extension direction F.

The filters 158 and 159 are components that filter out the byproducts or the powder in the inner space of the body 151. One of the filters 158 and 159 may be disposed between the inlet gas exhaust line connection 152 and the cooling water coil 155, and the other may be disposed between the cooling water coil 155 and the outlet gas exhaust line connection 153.

According to this configuration, the byproducts in the mixed gas may be solidified and become the powder by a cooling action of the cooling water flowing in the cooling water coil 155. The powder may accumulate in the inner space of the body 151. Even if there is some flowing powder, this powder may be prevented from being discharged outside the body 151 by the filters 158 and 159. The byproducts may be controlled, thus preventing the gas flow path following the capture module 150 from being clogged due to the byproducts.

As the powder accumulates, the capture module 150 itself may not have a permanent lifespan. As described above with reference to FIG. 4, a manager may need to measure the pressure in the gas exhaust line 141 to thus determine the lifespan of the capture module 150 and replace the same. When replacing the capture module 150, the manager may only need to disconnect the total of four connections, including the gas exhaust line connections 152 and 153 and the cooling water supply line connections 156 and 157. Accordingly, only the capture module 150 may be replaced with a new one, while the gas exhaust line 141 or the cooling water supply line 171 remain unchanged.

The high-pressure substrate processing apparatus described above is not limited to the configuration and operational methods in the embodiments described above. The embodiments described above may be variously modified by selective combinations of all or some of the respective embodiments.

### [Industrial Applicability]

The present invention has industrial applicability in a field of manufacturing a high-pressure substrate processing apparatus.

## Claims

1. A high-pressure substrate processing apparatus comprising:
an inner chamber accommodating a substrate to be processed;
an outer chamber including a hollow housing and a partition plate partitioning the housing into a high-temperature region accommodating the inner chamber and a low-temperature region having a lower temperature than the high-temperature region;
a gas supply module configured to supply a reaction gas for processing the substrate to the inner chamber at a first pressure higher than atmospheric pressure, and to supply a protective gas to a space between the outer chamber and the inner chamber at a second pressure set in relation to the first pressure;
a gas exhaust module including a gas exhaust line communicating with the inner chamber and passing through the low-temperature region and configured to exhaust a mixed gas including the reaction gas and byproducts occurring due to the processing; and
a capture module disposed in the low-temperature region while communicating with the gas exhaust line and configured to capture the byproducts in the mixed gas.

2. The apparatus of claim 1, wherein the gas exhaust module further includes a gas discharger installed at the gas exhaust line to be disposed outside the outer chamber and configured to regulate the mixed gas to be discharged to the outside through the capture module, and
the capture module is disposed in front of the gas discharger.

3. The apparatus of claim 1, further comprising a cooling water supply module including a cooling water supply line,
wherein the capture module is configured to cool the mixed gas by using cooling water flowing along the cooling water supply line, thus causing the byproducts to become powder.

4. The apparatus of claim 3, wherein the capture module includes
a pair of gas exhaust line connections detachably connected to the gas exhaust line, and
a pair of cooling water supply line connections detachably connected to the cooling water supply line.

5. The apparatus of claim 4, wherein the pair of gas exhaust line connections are arranged along an extension direction of the gas exhaust line, and
the pair of cooling water supply line connections are arranged along an intersecting direction intersecting the extension direction.

6. The apparatus of claim 3, wherein the cooling water supply module is configured to supply the cooling water to one of the housing and the partition plate to cool the low-temperature region.

7. The apparatus of claim 3, further comprising:
a detection module including a temperature sensor configured to measure a temperature in the gas exhaust line; and
a control module connected to the temperature sensor and the cooling water supply module,
wherein the control module is configured to regulate a temperature of the cooling water based on the temperature in the gas exhaust line that is acquired from the temperature sensor.

8. The apparatus of claim 7, wherein the cooling water supply module further includes a chiller configured to cool the cooling water, and
the control module operates the chiller to lower the temperature of the cooling water.

9. The apparatus of claim 1, further comprising:
a detection module including a pressure sensor configured to measure a pressure in the gas exhaust line at a rear end of the capture module; and
a control module connected to the pressure sensor,
wherein the control module is configured to output a replacement time of the capture module based on the pressure in the gas exhaust line that is acquired from the pressure sensor.

10. A high-pressure substrate processing apparatus comprising:
an inner chamber accommodating a substrate to be processed;
an outer chamber including a hollow housing accommodating the inner chamber;
a gas supply module configured to supply a reaction gas for processing the substrate to the inner chamber at a first pressure higher than atmospheric pressure, and to supply a protective gas to a space between the outer chamber and the inner chamber at a second pressure set in relation to the first pressure;
a gas exhaust module including a gas exhaust line communicating with the inner chamber and configured to exhaust a mixed gas including the reaction gas and byproducts occurring due to the processing to the outside of the outer chamber; and
a capture module disposed in the outer chamber while communicating with the gas exhaust line, exposed externally to the second pressure by the protective gas, exposed internally to the first pressure by the reaction gas, and configured to capture the byproducts in the mixed gas.

11. The apparatus of claim 10, wherein a difference between the first pressure and the second pressure is 2 atmospheres (ATM) or less.

12. The apparatus of claim 10, wherein the gas exhaust module further includes a gas discharger installed at the gas exhaust line and configured to regulate the exhaust of the mixed gas, and
the capture module is disposed in front of the gas discharger.

13. The apparatus of claim 10, further comprising a heating module configured to heat the reaction gas for processing the substrate,
wherein the outer chamber further includes a partition plate partitioning the housing into a high-temperature region accommodating the inner chamber and the heating module and a low-temperature region having a lower temperature than the high-temperature region, and
the low-temperature region is filled with cold air.

14. The apparatus of claim 13, further comprising a cooling water supply module,
wherein the capture module is configured to cool the mixed gas by using cooling water supplied by the cooling water supply module, thus causing the byproducts to become powder, and
the low-temperature region generates the cold air through the cooling water supplied to one of the housing and the partition plate by the cooling water supply module.
